# EUROPÄISCHE PATENTANMELDUNG

(11) **EP 4 850 843 A1**
(43) Veröffentlichungstag der Anmeldung: **09.12.2026**
(21) Anmeldenummer: 25181044.6
(22) Anmeldetag: 05.06.2025
(51) Int. Cl.: B23K 26/03, B23K 26/0622, B23K 26/382, H05K 3/00, B23K 101/42, B23K 103/16

(54) **VORRICHTUNG UND VERFAHREN ZUR LASERABLATION EINES MATERIALS VON EINER OBERFLÄCHE EINES WERKSTÜCKS MIT EINEM PULSLASER**

(71) Anmelder: Fraunhofer-Gesellschaft zur Förderung der angewandten Forschung e.V., 80686 München (DE)
(72) Erfinder: Basler, Carl, 79110 Freiburg (DE); Basler, Carl, 79110 Freiburg (DE)
(74) Vertreter: WSL Patentanwälte Partnerschaft mbB

(57) **Zusammenfassung**

Die vorliegende Erfindung betrifft eine Vorrichtung zur Laserablation eines Materials von einer Oberfläche eines Werkstücks mit einem Pulslaser, wobei der Pulslaser gepulste elektromagnetische Strahlung mit einer Pulsdauer von 100 Pikosekunden oder weniger, einer Schwerpunktwellenlänge und einer die Schwerpunktwellenlänge enthaltenden Bandbreite erzeugt und abstrahlt, und einer Fokussieroptik, wobei die Fokussieroptik derart ausgestaltet und angeordnet ist, dass sie in dem Betrieb der Vorrichtung die Ablationsstrahlung auf die Oberfläche des Werkstücks fokussiert. Erfindungsgemäß ist weiterhin vorgesehen, dass die Vorrichtung eine Detektionsoptik, ein dielektrisches Bandpassfilter mit einer FWHM-Bandbreite von 1 Nanometer oder weniger, einen Photomultiplier, eine Triggereinrichtung und eine Auswerteeinrichtung aufweist. Die Detektionsoptik ist erfindungsgemäß derart ausgestaltet und angeordnet, dass sie in dem Betrieb der Vorrichtung eine von einem Plasma an der Oberfläche des Werkstücks emittierte Plasmastrahlung sammelt und auf den Photomultiplier abbildet. Die Auswerteeinrichtung ist derart wirksam mit dem Photomultiplier verbunden, dass die Auswerteeinrichtung in dem Betrieb der Vorrichtung ein eine Intensität der Plasmastrahlung repräsentierendes Messignal von dem Photomultiplier erhält. Die Triggereinrichtung erzeugt für jeden Puls der Ablationsstrahlung ein den Beginn des Pulses kennzeichnendes Triggersignal und gibt dieses aus. Die Auswerteeinrichtung ist ferner derart wirksam mit der Triggereinrichtung verbunden, dass die Auswerteeinrichtung in dem Betrieb der Vorrichtung das Triggersignal erhält. Die Auswerteeinrichtung ist derart eingerichtet, dass sie in dem Betrieb der Vorrichtung für jeden Puls nach einer mit dem Triggersignal startenden, vorgegebenen Verzögerung das Messsignal über eine vorgegebene Integrationszeit integriert, so dass ein Intensitätsmaß erhalten wird, und ein Steuersignal aus dem Intensitätsmaß erzeugt und ausgibt.

## Beschreibung

Die vorliegende Erfindung betrifft eine Vorrichtung zur Laserablation eines Materials von einer Oberfläche eines Werkstücks mit einem Pulslaser, wobei der Pulslaser derart ausgestaltet ist, dass der Pulslaser in einem Betrieb der Vorrichtung gepulste elektromagnetische Strahlung mit einer Pulsdauer von 100 Pikosekunden oder weniger, einer Schwerpunktwellenlänge und einer die Schwerpunktwellenlänge enthaltenden Bandbreite erzeugt und abstrahlt, einer Fokussieroptik, wobei die Fokussieroptik derart ausgestaltet und angeordnet ist, dass sie in dem Betrieb der Vorrichtung die Ablationsstrahlung auf die Oberfläche des Werkstücks fokussiert.

Die vorliegende Erfindung betrifft zudem ein Verfahren zur Laserablation eines Materials von einer Oberfläche eines Werkstücks mit einem Pulslaser, wobei das Verfahren die Schritte aufweist: Erzeugen und Abstrahlen gepulster elektromagnetischer Ablationsstrahlung mit einer Pulsdauer von 100 Pikosekunden oder weniger, einer Schwerpunktwellenlänge und einer die Schwerpunktwellenlänge enthaltenden Bandbreite, und Fokussieren der Ablationsstrahlung auf die Oberfläche des Werkstücks, so dass von der Oberfläche des Werkstücks Material ablatiert wird.

Aus dem Stand der Technik ist es bekannt, gepulste Laser mit einer Pulsdauer von 100 Pikosekunden oder weniger zur Ablation von Material von der Oberfläche eines Werkstücks einzusetzen. Dabei werden Laser mit einer Pulsdauer von 100 Pikosekunden oder weniger auch als Ultrakurzpulslaser bezeichnet. Die Ablation von Material mithilfe eines Lasers, so dass ein Loch oder ein Durchgang entsteht, wird häufig auch als Laserbohren bezeichnet.

Bei der Laserablation erfolgt die Bearbeitung des Werkstücks berührungslos ohne Krafteintragung in das Bauteil. Die Laserstrahlung kann dank kleiner Optiken auch an schwer zugänglichen Stellen eingesetzt werden. Die Verwendung ultrakurzer Pulse zur Ablation ermöglicht es, Bohrungen mit hoher Bearbeitungsqualität zu realisieren, wobei gleichzeitig die thermische Belastung des Werkstücks gegenüber längeren Pulsen reduziert ist. Die Materialablation mittels Ultrakurzpulslaser ist jedoch nicht materialselektiv. Daher läuft die Ablation mit dem Pulslaser Gefahr, zu tief oder eben nicht tief genug ausgeführt zu werden.

Ein Beispiel für die Laserablation, die mit einem Ultrakurzpulslaser vorteilhaft durchgeführt werden kann, ist das Bohren von Microvias für die Strukturierung von Leiterplatten. Typische Leiterplatten weisen eine Sandwichstruktur auf mit einem isolierenden Trägermaterial und Metallisierungen auf jeder Fläche des Trägermaterials. Müssen die Metallisierungen punktgenau elektrisch leitend miteinander verbunden werden, so bohrt man durch die eine Metallisierung und das Trägermaterial hindurch, bis die andere Metallisierung erreicht ist. Abschließend wird die so entstandene Bohrung mit einem elektrischen Leiter verfüllt. Es ist unmittelbar verständlich, dass dann, wenn man zu weit bohrt, auch die zweite Metallisierung durchstoßen wird und es nicht mehr möglich sein wird, die beiden Metallisierungen zuverlässig elektrisch leitend miteinander zu verbinden. Andererseits führt eine nicht tief genug ausgeführte Bohrung zu keiner zuverlässigen Kontaktierung zwischen den Metallisierungen, da das Via durch das nicht entfernte, isolierende Trägermaterial der Leiterplatte unterbrochen ist.

Daher ist es eine Aufgabe der vorliegenden Erfindung, eine Vorrichtung und ein Verfahren zur Laserablation eines Materials von einer Oberfläche eines Werkstücks mit sehr kurzen Pulsen bereitzustellen, die es ermöglichen, das Ergebnis der Ablation zu überwachen und in Abhängigkeit von diesem Ergebnis auf die weitere Ablation einzuwirken oder ein fehlerhaftes Werkstück auszusortieren.

Die zuvor genannte Aufgabe wird durch eine Vorrichtung zur Laserablation eines Materials von einer Oberfläche eines Werkstücks gemäß dem unabhängigen Anspruch 1 gelöst. Dazu weist die Vorrichtung der eingangs genannten Art weiterhin eine Detektionsoptik, ein dielektrisches Bandpassfilter mit einer FWHM-Bandbreite von 1 Nanometer oder weniger, einen Photomultiplier, eine Triggereinrichtung und eine Auswerteeinrichtung auf. Die Detektionsoptik ist erfindungsgemäß derart ausgestaltet und angeordnet, dass sie in dem Betrieb der Vorrichtung eine von einem Plasma an der Oberfläche des Werkstücks emittierte Plasmastrahlung sammelt und auf den Photomultiplier abbildet. Das Bandpassfilter ist in einem Strahlengang der Plasmastrahlung zwischen der Oberfläche und dem Photomultiplier angeordnet, wobei das Bandpassfilter eine Durchlasswellenlänge für die Plasmastrahlung aufweist und wobei die Durchlasswellenlänge außerhalb der Bandbreite des Pulslasers liegt. Die Auswerteeinrichtung ist derart wirksam mit dem Photomultiplier verbunden, dass die Auswerteeinrichtung in dem Betrieb der Vorrichtung ein eine Intensität der Plasmastrahlung repräsentierendes Messignal von dem Photomultiplier erhält. Die Triggereinrichtung erzeugt für jeden Puls der Ablationsstrahlung ein den Beginn des Pulses kennzeichnendes Triggersignal und gibt dieses aus. Die Auswerteeinrichtung ist ferner derart wirksam mit der Triggereinrichtung verbunden, dass die Auswerteeinrichtung in dem Betrieb der Vorrichtung das Triggersignal erhält. Die Auswerteeinrichtung ist derart eingerichtet, dass sie in dem Betrieb der Vorrichtung für jeden Puls nach einer mit dem Triggersignal startenden, vorgegebenen Verzögerung das Messsignal über eine vorgegebene Integrationszeit integriert, so dass ein Intensitätsmaß erhalten wird, und ein Steuersignal aus dem Intensitätsmaß erzeugt und ausgibt.

Es ist die der vorliegenden Erfindung zugrunde liegende Idee, das Ergebnis des Ablationsvorgangs mithilfe laserinduzierter Plasmaspektroskopie (englisch Laser-Induced Breakdown Spectroscopy, kurz LIBS) zu erfassen. Dabei hat sich herausgestellt, dass bei ultrakurzen Pulsen mit einer Pulsdauer von 100 Pikosekunden oder weniger die bisherigen Konzepte der laserinduzierten Plasmaspektroskopie, so wie sie bei längeren Pulsen zum Einsatz kommen, versagen. Ursächlich für die Komplikationen bei der Anwendung der laserinduzierten Plasmaspektroskopie bei der Laserablation mit ultrakurzen Pulsen ist die sehr geringe Lichtmenge der Plasmaemission. Diese ist zum einen auf die geringen Pulsenergien der ultrakurzen Pulse zurückzuführen, welche das Plasma anregen, zum anderen auf die kurzen Abklingzeiten des Plasmas (etwas 100 Nanosekunden). Daher gilt es, die sehr geringe Intensität der Plasmastrahlung zuverlässig zu erfassen.

Zu diesem Zweck sieht die vorliegende Erfindung drei wesentliche Maßnahmen vor. Zum einen schränkt ein dielektrisches Bandpassfilter mit einer Full Width Half Maximum- (FWHM-) Bandbreite von 1 Nanometer oder weniger die auf den Photomultiplier fallende Plasmastrahlung auf die atomare bzw. molekulare Emissionslinie eines chemischen Elements oder eines Moleküls des abzutragenden Materials, insbesondere des abzutragenden Materials einer Schicht des Werkstücks, spektral ein.

Die Triggereinrichtung ermöglicht es, die Integration des Messsignals präzise und Puls für Puls wiederholbar nach einer voreingestellten Verzögerung zu starten. Diese Verzögerung ist notwendig, um die vom Plasma bei und unmittelbar nach der Anregung ausgehende thermische Strahlung zeitlich zu unterdrücken. Mit der vorliegenden Erfindung werden somit alle Hintergrundsignale zeitlich und spektral weitgehend diskriminiert.

Der Photomultiplier ermöglicht es, geringe Photonenzahlen zuverlässig zu erfassen.

Ein schmalbandiges dielektrisches Bandpassfilters weist verglichen mit einer herkömmlichen, in einem Spektrometer für die laserinduzierte Plasmaspektroskopie verwendeten Gitteranordnung mit einem engen Eingangs- und Ausgangsspalt einen erheblich verringerten Intensitätsverlust auf.

Das Erzeugen des Steuersignals ist in einer Ausführungsform darauf reduziert, dass das Steuersignal gleich dem Intensitätsmaß ist. In einer Ausführungsform ist die Auswerteeinrichtung oder einer dieser nachgelagerte Signal- oder Datenverarbeitungseinheit derart eingerichtet, dass sie einen Vergleich des Intensitätsmaßes mit einem vorgegebenen Schwellenwert durchführt. Wird der Vergleich von der Auswerteeinrichtung ausgeführt, so erzeugt die Auswerteeinrichtung das Steuersignal in Abhängigkeit von dem diesem Vergleich.

Das von der Auswerteeinrichtung erzeugte und ausgegebene Steuersignal kann auf verschiedene Weise zur Prozessüberwachung eingesetzt werden.

Beim Bohren von Vias in einer Leiterplatte mit zwei durch ein elektrisch isolierendes Trägermaterial getrennten Metallisierungen gilt es beispielsweise zu verhindern, dass die Bohrung die zweite Metallisierung durchstößt. Erfasst man während des Ablationsprozesses das Metall, beispielsweise Kupfer, der zweiten Metallisierung, so ist die erforderliche Bohrtiefe erreicht und der Laser kann beispielsweise abgeschaltet oder seine Intensität reduziert werden.

Zum einen ist es möglich, dass das Steuersignal ein Fehlersignal ist, welches anzeigt, dass bei der Ablation des zu bearbeitenden Werkstücks ein Fehler unterlaufen ist. Dieses Werkstück kann dann in einem späteren Schritt als fehlerhaft aussortiert oder markiert werden.

In einer Ausführungsform der Erfindung ist die Auswerteeinrichtung derart wirksam mit dem Pulslaser verbunden, dass der Pulslaser in dem Betrieb der Vorrichtung das Steuersignal von der Auswerteeinrichtung erhält, wobei der Pulslaser derart ausgestaltet ist, dass er in dem Betrieb der Vorrichtung die Ablationsstrahlung in Abhängigkeit von dem Steuersignal erzeugt. In einer solchen Ausführungsform schaltet das Steuersignal den Pulslaser ein oder aus oder ändert die Ablationsintensität der Ablationsstrahlung.

In einer alternativen Ausführungsform wird das Steuersignal zum Schreiben einer Abtragskarte für eine nächste Abtragsebene verwendet. Die erfindungsgemäße Implementierung der Auswertung des Messsignals ermöglicht das Erstellen einer solchen Abtragskarte in Echtzeit, so dass die Bearbeitungsdauer des Werkstücks reduziert ist. In einer Ausführungsform wird die Ablationsstrahlung von einer Ablenkeinheit über die Oberfläche des Werkstücks geführt. Die Ablation entsteht dann durch ein Rastern einer Vielzahl von Punkten auf der Oberfläche mit dem Fokus der Ablationsstrahlung. In einer solchen Ausführungsform kann es vorkommen, dass an einem bestimmten Punkt bereits die Metallisierung erreicht wird, während an anderen Punkten noch weiteres elektrisch isolierendes Material abzutragen ist. Dann wird in der nächsten Ebene der Materialabtragung nur dort Material abgetragen, wo in der vorangegangenen Ebene noch kein Metall erreicht war. In einer Ausführungsform der Erfindung ist daher die Auswerteeinrichtung derart ausgestaltet, dass sie eine Abtragskarte für eine folgende Ebene der Ablation in Abhängigkeit von den Steuersignal generiert.

In einer Ausführungsform der Erfindung hat der Pulslaser eine Pulsdauer von 15 Pikosekunden oder weniger, vorzugsweise von 10 Pikosekunden oder weniger.

In einer Ausführungsform der Erfindung ist die Auswerteeinrichtung als analogelektronische Schaltung implementiert.

In einer Ausführungsform der Erfindung umfasst die Schaltung einen Schalter und einen Integrator. Dabei ist der Schalter derart wirksam mit dem Photomultiplier verbunden, dass der Schalter in dem Betrieb der Vorrichtung das Messsignal von dem Photomultiplier erhält. Der Schalter ist derart wirksam mit der Triggereinrichtung verbunden, dass der Schalter in dem Betrieb der Vorrichtung das Triggersignal von der Triggereinrichtung erhält. Der Schalter ist derart ausgestaltet, dass der Schalter in dem Betrieb der Vorrichtung das Messsignal nur nach dem Erhalt des Triggersignals an den Integrator durchlässt. Auf diese Weise wird die erforderliche zeitliche Verzögerung zum Diskriminieren der thermischen Strahlung von dem Plasma bewirkt. Der Integrator ist derart wirksam mit dem Schalter verbunden, dass der Integrator in dem Betrieb der Vorrichtung das Messsignal von dem Schalter erhält. Der Integrator ist derart ausgestaltet, dass er in dem Betrieb der Vorrichtung das Messsignal über die Integrationszeit integriert, so dass das Intensitätsmaß erhalten wird.

Eine derartige analogelektronische Ausgestaltung weist gegenüber einer digitalelektronischen Auswertung, welche die Digitalisierung eines vollständigen zeitlichen Verlaufs des Messsignals erfordert, den Vorteil auf, dass sie die schnelle Erfassung der von einzelnen Pulsen generierten Plasmastrahlung ermöglicht und damit eine Überwachung in Echtzeit erlaubt.

In einer Ausführungsform umfasst die Schaltung zudem einen Verstärker. Dabei ist er derart wirksam mit dem Schalter verbunden, dass in dem Betrieb der Vorrichtung der Verstärker das Messsignal von dem Schalter erhält. Der Verstärker ist zudem derart ausgestaltet, dass der Verstärker in dem Betrieb der Vorrichtung das Messsignal verstärkt und ein verstärktes Messsignal erzeugt. Der Integrator wiederum ist derart wirksam mit dem Verstärker verbunden, dass der Integrator in dem Betrieb der Vorrichtung das verstärkte Messignal von dem Verstärker erhält.

In einer Ausführungsform umfasst die Schaltung weiterhin einen Komparator. Dabei ist der Komparator derart wirksam mit dem Integrator verbunden, dass der Komparator in dem Betrieb der Vorrichtung das Intensitätsmaß von dem Integrator erhält. Der Komparator ist derart ausgestaltet, dass er in dem Betrieb der Vorrichtung das Intensitätsmaß mit einem vorgebebnen Referenzsignal vergleicht und das Steuersignal in Abhängigkeit von diesem Vergleich erzeugt.

In einer Ausführungsform stellt die Schaltung das Steuersignal zumindest an einem analogen Ausgang oder an einem digitalen Ausgang zur Verfügung.

In einer Ausführungsform der Erfindung ist die Auswerteeinrichtung, d.h. insbesondere der Integrator, derart eingerichtet, dass die Integrationszeit in einem Bereich von 5 Nanosekunden bis 300 Nanosekunden liegt. Dabei gilt es, die Integrationszeit so lange wie möglich zu wählen, um möglichst viele Photonen, welche zum Messsignal beitragen können, zu berücksichtigen. Die Länge der Integrationszeit ist im Wesentlichen durch die Abklingzeit des Plasmas und die Pulswiederholrate der Ablationsstrahlung bestimmt.

In einer Ausführungsform der Erfindung ist das Bandpassfilter Bestandteil einer Einrichtung mit einer Mehrzahl von Bandpassfiltern, wobei die Einrichtung derart ausgestaltet ist, dass die Mehrzahl von Bandpassfiltern automatisiert gegeneinander im Strahlpfad der Plasmastrahlung austauschbar sind. Auf diese Weise kann eine Mehrzahl von Zielwellenlängen der Plasmastrahlung für voneinander verschiedene Materialien des Werkstücks ausgewertet werden.

In einer Ausführungsform ist der Photomultiplier ausgewählt aus einer Gruppe bestehend aus einer Photomultiplier-Tube (PMT), einem Mikrokanalplatten-Photomultiplier (engl. micro channel plate photomultiplier, MCP-PMT oder kurz MCP), einer Avalanche Photodiode (APD), oder einem Silizium Photomultiplier (SiPM).

Insbesondere ein Silizium Photomultiplier ermöglicht es, geringe Photonenzahlen zuverlässig bei geringen Stückkosten zu erfassen.

In einer Ausführungsform der Erfindung weist der Photomultiplier eine Bandbreite von 100 Megahertz (f_{-3dB} Frequenzantwort) oder mehr auf.

Die Winkelverteilung der Emission der Plasmastrahlung in dem laserinduzierten Plasma ist vorwiegend isotrop. Daher ist es möglich, denjenigen Teil der Plasmastrahlung, der kollinear mit der Ablationsstrahlung propagiert, mit dem Photomultiplier zu erfassen. Dazu ist in einer Ausführungsform ein dielektrischer Spiegel im Strahlengang der Ablationsstrahlung angeordnet, sodass die kollinear mit der Ablationsstrahlung propagierende Plasmastrahlung aus dem Strahlengang der Ablationsstrahlung heraus und auf den Photomultiplier reflektiert wird.

In einer alternativen Ausführungsform jedoch umfasst die Detektionsoptik eine optische Faser mit einem Kerndurchmesser von mehr als 750 Mikrometer, wobei die Faser derart angeordnet ist, dass sie in dem Betrieb der Vorrichtung die Plasmastrahlung von der Oberfläche zu dem Photomultiplier leitet, und wobei eine Ablenkoptik derart angeordnet und ausgestaltet ist, dass in dem Betrieb der Vorrichtung ein Fokus der Ablationsstrahlung gegenüber einer Endfläche der Faser bewegbar ist. Dieser Ausführungsform liegt die Idee zu Grunde, einen nicht kollinear zu der Ablationsstrahlung emittierten Teil der Plasmastrahlung zu erfassen. Eine solche Ausführungsform ist vorteilhaft, da sie es vermeidet, beispielsweise mit einem Spiegel in den Strahlengang der Ablationsstrahlung einzugreifen. Da in den meisten Vorrichtungen für die Laserablation der Fokus während der Ablation mittels einer Ablenkoptik bewegt wird, ist es wesentlich, dass die optische Faser zum Führen der Plasmastrahlung einen großen Kerndurchmesser aufweist, um die Plasmastrahlung von einer Mehrzahl von Orten auf der Oberfläche des Werkstücks einsammeln zu können. Es versteht sich, dass die Endfläche der Faser einen Winkel ungleich 90 Grad mit der Strahlachse der Ablationsstrahlung beim Auftreffen auf die Oberfläche des Werkstücks einschließt.

In einer Ausführungsform der Erfindung weist die Vorrichtung mindestens ein erstes und zweites dielektrisches Bandpassfilter mit einer ersten und einer von der ersten verschiedenen zweiten Durchlasswellenlänge auf. Dabei umfasst die Vorrichtung auch einen ersten und einen zweiten Photomultiplier, wobei das erste und das zweite Bandpassfilter sowie der erste und der zweite Photomultiplier derart angeordnet sind, dass mit dem ersten Photomultiplier Plasmastrahlung mit einer ersten Wellenlänge und mit dem zweiten Photomultiplier Plasmastrahlung mit einer zweiten Wellenlänge erfassbar ist.

Es ist möglich, mit mehreren Detektoren, insbesondere einem ersten und einem zweiten Photomultiplier, gleichzeitig das Plasma von unterschiedlichen ablatierten Materialien zu erfassen.

In einer alternativen Ausführungsform ist es möglich, eine Mehrzahl von Detektoren, insbesondere den ersten und den zweiten Photomultiplier, zum Erfassen des Materials und eines Hintergrundsignals zu verwenden. Dabei bildet man dann als Messsignal die Differenz zwischen den Messsignalen des ersten und des zweiten Photomultipliers.

In einer Ausführungsform kann für die Plasmastrahlung sowie für ein zu erfassendes Hintergrundsignal ein einziges dielektrisches Bandpassfilter verwendet werden. Dabei erfolgt die Strahlführung so, dass zwei Teilstrahlen leicht gegeneinander verkippt durch das gleiche dielektrische Bandpassfilter geleitet werden, sodass beide Teilstrahlen voneinander verschiedene Filtercharakteristiken des Bandpassfilters erfahren.

In einer Ausführungsform der Erfindung ist der Pulslaser derart ausgestaltet, dass er in dem Betrieb der Vorrichtung die Pulse mit einer Repetitionsrate aus einem Bereich von 50 Kilohertz bis 1 Megahertz erzeugt.

Die zuvor genannte Aufgabe wird auch durch ein Verfahren zur Laserablation eines Materials von einer Oberfläche eines Werkstücks gemäß dem darauf gerichteten unabhängigen Anspruch gelöst. Dazu weist das Verfahren zusätzlich die Schritte auf: Erzeugen eines den Beginn des Pulses kennzeichnenden Triggersignals für jeden Puls der Ablationsstrahlung, Abbilden einer von einem durch die Ablationsstrahlung an der Oberfläche des Werkstücks generiertem Plasma emittierten Plasmastrahlung auf einen Photomultiplier, Filtern der Plasmastrahlung zwischen der Oberfläche und dem Photomultiplier mit einem dielektrischen Bandpassfilter mit einer FWHM Bandbreite von 1 Nanometer oder weniger, wobei das Bandpassfilter eine Durchlasswellenlänge aufweist, wobei die Durchlasswellenlänge außerhalb der Bandbreite des Pulslasers liegt, Erfassen einer Intensität der Plasmastrahlung mit dem Photomultiplier, wobei der Photomultiplier ein die Intensität repräsentierendes Messsignal ausgibt, Integrieren des Messsignals für jeden Puls nach einer mit dem Triggersignal startenden, vorgegebenen Verzögerung über eine vorgegebene Integrationszeit, so dass ein Intensitätsmaß erhalten wird, Erzeugen eines Steuersignals aus dem Intensitätsmaß und Ausgeben des Steuersignals.

In einer Ausführungsform weist das Verfahren weiterhin den Schritt auf: Vergleichen des Intensitätsmaßes mit einem vorgegebenen Schwellenwert und Erzeugen des Steuersignals in Abhängigkeit von dem Vergleich.

In einer Ausführungsform der Erfindung ist das Werkstück eine Leiterplatte mit einer elektrisch isolierenden Trägerschicht, einer ersten elektrisch leitenden Schicht und einer zweiten durch die Trägerschicht gegenüber ersten elektrisch leitenden Schicht elektrisch isolierten zweiten elektrisch leitenden Schicht. Durch die Laserablation wird ein Durchgang von der ersten Schicht zu der zweiten Schicht bereitgestellt. Ein solcher Durchgang wird auch als Via bezeichnet.

In einer Ausführungsform der Erfindung wird die Ablationsstrahlung über die Oberfläche des Werkstücks geführt.

In einer Ausführungsform der Erfindung umfasst die Triggereinrichtung einen Abschnitt, der in den Pulslaser integriert ist und ein zu der Pulsfolge der Ablationsstrahlung synchronisiertes Triggersignal erzeugt.

In einer alternativen Ausführungsform umfasst die Triggereinrichtung einen Triggerdetektor und ein Auskoppelement. Dabei ist das Auskoppelement in einem Strahlengang der Ablationsstrahlung oder der Plasmastrahlung in Strahlrichtung nach dem Werkstück angeordnet, sodass das Auskoppelelement zumindest einen Teil der Ablationsstrahlung oder einen Teil der Plasmastrahlung auf den Triggerdetektor lenkt. Der Triggerdetektor erzeugt das Triggersignal als Initialtrigger für die Auswerteeinrichtung.

Das Auskoppelement ist in einer Ausführungsform ein teildurchlässiger Spiegel der Detektionsoptik. In einer Ausführungsform ist das Auskoppelement ein Element der Detektionsoptik, welches zur Strahlformung der auf den Photomultiplier zu leitenden Plasmastrahlung verwendet wird. Beispielsweise kann das Auskoppelelement eine Kollimationslinse oder eine Fokussierlinse der Auskoppeloptik der Faser der Detektionsoptik sein. Genutzt wird dann ein Rückreflex von einem dieser strahlformenden Elemente, der ohnehin nicht auf den Photomultiplier gelangen würde. In einer Ausführungsform ist das Auskoppelelement das Bandpassfilter, welches unter einem von 90 Grad verschiedenen Winkel zur Strahlachse der Plasmastrahlung angeordnet ist. Auch in diesem Fall wird ein Teil der Plasmastrahlung oder der Ablationsstrahlung auf den Triggerdetektor geleitet, der ohnehin nicht zum Messsignal beiträgt.

Auf diese Weise lässt sich mit dem Triggerdetektor nicht nur das Triggersignal erzeugen, sondern in einer Ausführungsform auch ein Referenzsignal, welches Variationen der Ablationsstrahlung erfasst. Beispielsweise kann das Messsignal des Photomultipliers auf das Referenzsignal normiert werden.

In einer Ausführungsform gelangt nur Plasmastrahlung auf den Triggerdetektor. In einer Ausführungsform ist in Strahlrichtung vor dem Triggerdetektor ein optisches Filter angeordnet, welches die Ablationsstrahlung herausfiltert, so dass nur ein Teil der Plasmastrahlung auf den Triggerdetektor gelangt.

Weitere Vorteile, Merkmale und Anwendungsmöglichkeiten der vorliegenden Erfindung werden anhand der folgenden Beschreibung einer Ausführungsform und der dazugehörigen Figuren deutlich. In den Figuren sind gleiche Elemente mit identischen Bezugszeichen bezeichnet.
- Figur 1: ist eine schematische Darstellung einer Ausführungsform der erfindungsgemäßen Vorrichtung.
- Figur 2: ist eine vergrößerte, schematische Darstellung der Detektionsoptik der Vorrichtung aus Figur 1.
- Figur 3: ist eine schematische Darstellung der Auswerteeinrichtung der Vorrichtung aus Figur 1.

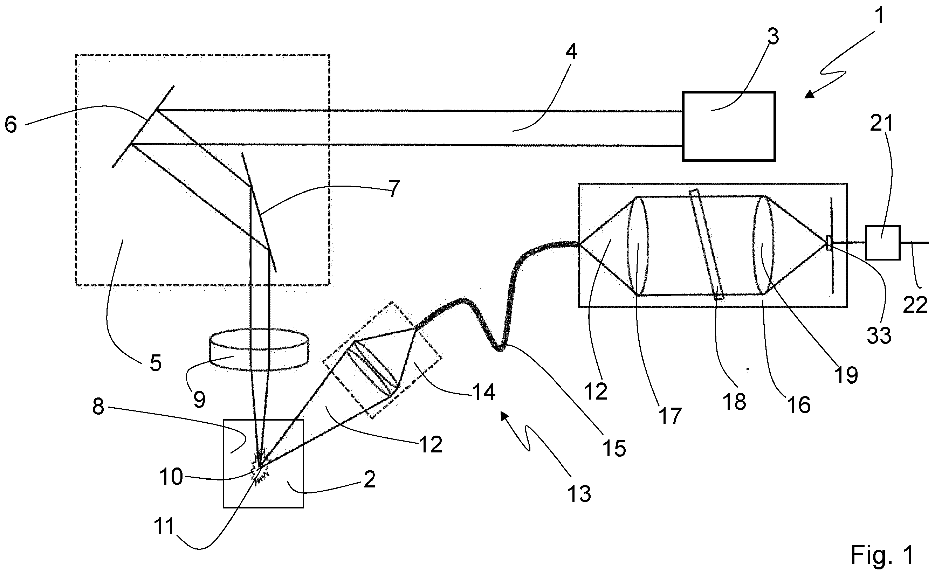

Die Vorrichtung 1 aus Figur 1 dient dazu, ein Via in eine Leiterplatte 2 als Werkstück zu bohren. Dabei umfasst die Leiterplatte 2 neben einem elektrisch nicht leitfähigen Träger zwei auf die ausgedehnten Oberflächen des Trägers aufgebrachte Metallschichten aus Kupfer. Beispielhaft gilt es dabei zu erfassen, wann das Via eine Tiefe erreicht hat, sodass die zweite Metallschicht erreicht ist. Dann kann der Durchgang in einem späteren Prozessschritt mit Metall gefüllt werden, um die eine Metallschicht mit der anderen elektrisch leitend zu verbinden. Erfolgt der Abtrag des elektrisch isolierenden Materials des Trägers nicht vollständig, so wird die elektrisch leitfähige Verbindung nicht zustande kommen. Wird anderenfalls die zweite Metallschicht ebenfalls durchstoßen, so kann es aus prozesstechnischen Gründen schwierig werden, die elektrisch leitende Verbindung zwischen den beiden Metallschichten bereitzustellen.

Das Via wird mittels eines Laserablationsverfahrens in die Leiterplatte 2 eingebracht. Zu diesem Zweck erzeugt ein optischer Kurzpulslaser 3 elektromagnetische Ablationsstrahlung 4 mit einer Pulsdauer von 5 Pikosekunden, einer Repetitionsrate von 1 Megahertz und einer Energie von 100 Mikrojoule pro Puls.

Die Ablationsstrahlung 4 wird mithilfe einer Ablenkeinheit 5 mit zwei schwenkbaren Spiegeln 6, 7 auf die Oberfläche 8 der Leiterplatte 2 weitergeleitet. Die Spiegel 6, 7 sind Galvanometerscanner, wobei die beiden Spiegel 6, 7 um zueinander senkrechte Schwenkachsen verschwenkt werden. Ein Scanobjektiv 9 (f-θ-Linse) fokussiert die Ablationsstrahlung 4 auf die Oberfläche 8 der Leiterplatte 2, so dass auf der Oberfläche ein Fokus mit einem Durchmesser von etwa 30 Mikrometer erzeugt wird. Die Ablenkung und Fokussierung zusammen ermöglichen es, einen sehr kleinen Fokus 10 sehr präzise über die Oberfläche 8 der Leiterplatte 2 zu führen und die Oberfläche 8 der Leiterplatte 2 Punkt für Punkt zu ablatieren.

Im Bereich des Fokus 10 wird beim Ablatieren des Materials der Leiterplatte 2 ein Plasma 11 generiert. Dieses Plasma 11 ist Quelle von Plasmastrahlung 12 sowie unmittelbar bei Entstehung und kurz danach des Plasmas von thermischer Strahlung. Die Wellenlänge der emittierten Plasmastrahlung 12 ist charakteristisch für das ablatierte Material, das zur Entstehung des Plasmas 11 beiträgt. Erfasst man die Linie der Plasmastrahlung 12, die für ein Material charakteristisch ist, so kann man davon ausgehen, dass dieses Material mit dem entsprechenden Puls der Ablationsstrahlung 4 von der Oberfläche 8 der Leiterplatte 2 abgetragen wurde.

Exemplarisch soll in der gezeigten Ausführungsform erfasst werden, wenn die Ablationsstrahlung 4 nach dem Durchstoßen der ersten Metallisierung und des Trägermaterials der Leiterplatte 2 zum zweiten Mal beginnt Kupfer abzutragen. Dann ist notwendigerweise das elektrisch isolierende Trägermaterial der Leiterplatte 2 durchbrochen.

In der gezeigten Ausführungsform wird die Plasmastrahlung 12 von einer Detektionsoptik 13 auf einen Silizium Photomultiplier 33 abgebildet. Dabei umfasst die Detektionsoptik 13 eine Einkoppeloptik 14, welche die Plasmastrahlung 12 in eine optische Faser 15 mit einem Kerndurchmesser von 1 Millimeter fokussiert und dann zu einer Multipliereinheit 16 leitet. Die Multipliereinheit 16 umfasst in der dargestellten Variante neben dem Silizium Photomultiplier 33 eine Kollimieroptik 17, ein dielektrisches Bandpassfilter 18 sowie eine Fokussieroptik 19. Die Kollimieroptik 17 und die Fokussieroptik 19 sind Teil der Detektionsoptik 13. Die Kollimieroptik 17 kollimiert die aus der Faser 15 austretende Plasmastrahlung 12 und die Fokussieroptik bündelt die Plasmastrahlung 12 auf den Silizium Photomultiplier 33.

Das dielektrische Bandpassfilter 18 hat eine FWHM-Bandbreite von 0,6 Nanometer um eine Schwerpunktwellenlänge von 521,8 Nanometer, sodass nur Strahlung auf den Silizium Photomultiplier 33 gelangt, die schmalbandig um die charakteristische Emissionslinie von Kupfer in dem Plasma 11 herum liegt.

Diese Anordnung aus der die Plasmastrahlung 12 sammelnden Einkoppeloptik 14, dem Bandpassfilter 18 und dem Silizium Photomultiplier 33 ermöglicht es, die geringe Lichtintensität der Plasmastrahlung 12 effizient zu erfassen. Gleichzeitig bewirkt das dielektrische Bandpassfilter eine spektrale Diskriminierung von nicht zum relevanten Signal beitragender Hintergrundstrahlung.

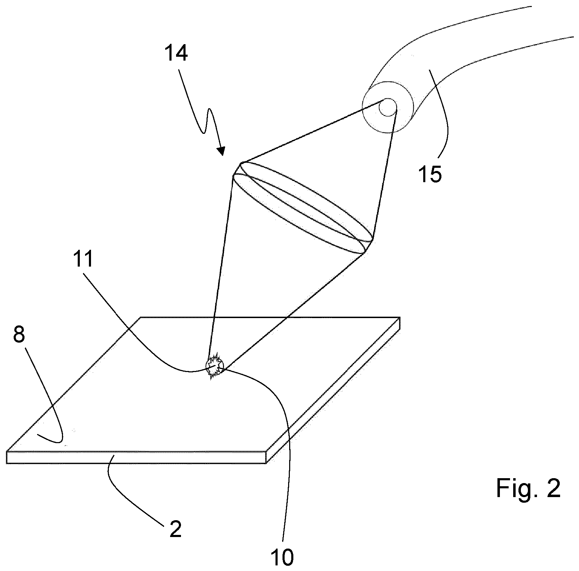

Figur 2 zeigt eine perspektivische, vergrößerte Darstellung der Einkoppeloptik 14 sowie der Faser 15 in einer isometrischen Darstellung. Gut zu erkennen ist, dass diese Faserkopplung es ermöglicht, die Plasmastrahlung 12 unter einem anderen Winkel als dem Auftreffwinkel der Ablationsstrahlung 4 auf der Oberfläche 8 der Leiterplatte 2 zu erfassen. Zudem ermöglicht der große Kerndurchmesser der Faser 15 das Einkoppeln von Plasmastrahlung von verschiedenen Punkten auf der Oberfläche 8 der Leiterplatte 2, ohne dass die Einkoppeloptik 14 und die Faser 15 nachgeführt werden müssen.

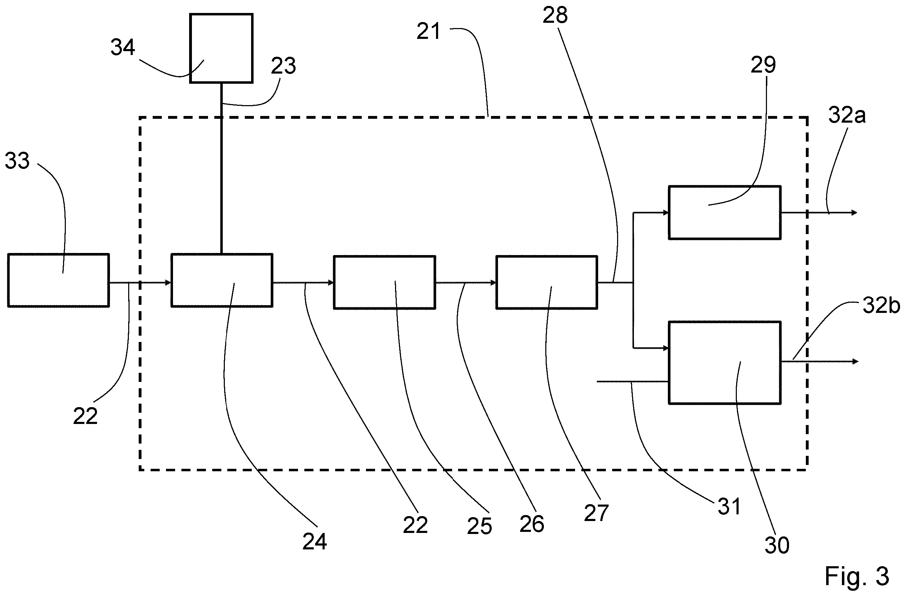

Allerdings gelangt neben der Plasmastrahlung 12 auch ein Teil der thermischen Strahlung des Plasmas 11 auf den Silizium Photomultiplier 33. Diese thermische Strahlung wird bei und kurz nach der Zündung des Plasmas 11 von diesem generiert wird. Daher wird erfindungsgemäß das Messsignal 20 des Silizium Photomultipliers 14 mittels einer Analogelektronik 21 ausgewertet, um ein Steuersignal 32a, 32b zu generieren. Die Funktionsweise der Analogelektronik 21 ist schematisch in Figur 3 dargestellt.

Der Silizium Photomultiplier 33 erzeugt bei Lichteinfall der Plasmastrahlung 12 einen die Intensität der Plasmastrahlung 12 widerspiegelnden Strom als Messsignal 22. Um den in diesem Messsignal 22 enthaltenen, auf die charakteristischen Übergänge in dem Plasma zurückgehenden Anteil auswerten zu können, weist die Analogschaltung 21 einen schnellen Schalter 24, einen invertierenden Verstärker 25 sowie einen Integrator 27 auf.

Der schnelle Schalter 24 ist so konfiguriert, dass er das Messignal 22 erst nach einer einstellbaren Verzögerungszeit nach dem Eintreffen eines Triggersignals 23 schaltet. Dabei ist das Triggersignal 23 auf die Pulse der Ablationsstrahlung 4 synchronisiert. Die Verzögerungszeit beträgt 20 Nanosekunden ab dem Triggersignal 23.

Nach der vorgegebenen Verzögerungszeit lässt der schnelle Schalter 24 das Messsignal 22 an den invertierenden Verstärker 25 durch. Den vor dem Ablauf der vorgegebenen Verzögerung auftretenden Signalanteil, der primär auf die von dem Plasma generierte thermische Strahlung zurückzuführen ist, lässt der schnelle Schalter 24 hingegen nicht durch; dieser Anteil wird bei der weiteren Signalauswertung zeitlich diskriminiert. Der invertierende Verstärker verstärkt das durchgeleitete Messsignal 22 und kehrt dessen Polarität um, um das Messsignal 22 an die nachfolgenden Verarbeitungsstufen anzupassen.

Das verstärkte und invertierte Messsignal 26 bildet den Eingang eines Integrators 27. Der Integrator 27 integriert das verstärke Messsignal über die Integrationszeit hinweg. Die Integrationszeit beginnt mit Ablauf der Verzögerungszeit. In der dargestellten Ausführungsform beträgt die Integrationszeit 200 Nanosekunden. Diese Integrationszeit ist bestimmt durch die zeitliche Periode der Repetitionsrate des Lasers sowie die von dem schnellen Schalter 24 vorgegebene Verzögerungszeit.

Nach dem Integrieren erhält man ein Signal, welches ein Intensitätsmaß 28 der Intensität der von dem Plasma 11 generierten Plasmastrahlung 12 ist. Dieses Intensitätsmaß 28 wird bei der in Figur 3 gezeigten Ausführungsform der Schaltung 21 als analoger Ausgang 32a und als digitaler Ausgang 32b ausgegeben. Im analogen Ausgang 32a ist ein Track-and-Hold-Glied 29 vorgesehen. Dieses hält das Intensitätsmaß 28 für eine bestimmte Zeit fest, um eine spätere präzise Verarbeitung zu ermöglichen.

Die Umwandlung des Intensitätsmaßes 28 in ein Digitalsignal, das am digitalen Ausgang 32b abgegriffen werden kann, erfolgt mithilfe eines Komparators 30. Dieser vergleicht das Intensitätsmaß 28 mit einem einstellbar vorgegebenen elektronischen Referenzsignal 31. Überschreitet das Intensitätsmaß 28 das Referenzsignal 31, so erzeugt der Komparator 30 einen vorgegebenen Ausgangspegel. Der digitale Ausgang 32b ist daher entweder Null, wenn die integrierte Intensität der Plasmastrahlung 12 unter dem von dem Referenzsignal 31 vorgegebenen Schwellenwert liegt oder Eins, wenn die Intensität der Plasmastrahlung 12 über einem Schwellenwert liegt. Liegt die Intensität der Plasmastrahlung 12 über dem Schwellenwert, so ist davon auszugehen, dass das durch diese Wellenlänge charakterisierte Kupfer mittels der Ablationsstrahlung 4 ablatiert wurde und den entsprechenden Übergang in dem Plasma 11 erzeugt hat.

In der gezeigten Ausführungsform dient das Steuersignal im analogen Ausgang 32a der Schaltung 21 der Regelung des Kurzpulslasers 3. Dazu ist der analoge Ausgang 23a mit dem Kurzpulslaser 3 verbunden. Übersteigt das Steuersignal 32a einen am Kurzpulslaser 3 eingestellten Schwellenwert, so wird der Kurzpulslaser 3 ausgeschaltet, da der Grund des zu bohrenden Via die zweite Metallschicht der Leiterplatte 2 erreicht hat.

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

Während die Erfindung im Detail in den Zeichnungen und der vorangehenden Beschreibung dargestellt und beschrieben wurde, erfolgt diese Darstellung und Beschreibung lediglich beispielhaft und ist nicht als Beschränkung des Schutzbereichs gedacht, so wie er durch die Ansprüche definiert wird. Die Erfindung ist nicht auf die offenbarten Ausführungsformen beschränkt.

Abwandlungen der offenbarten Ausführungsformen sind für den Fachmann aus den Zeichnungen, der Beschreibung und den beigefügten Ansprüchen offensichtlich. In den Ansprüchen schließt das Wort "aufweisen" nicht andere Elemente oder Schritte aus, und der unbestimmte Artikel "eine" oder "ein" schließt eine Mehrzahl nicht aus. Die bloße Tatsache, dass bestimmte Merkmale in unterschiedlichen Ansprüchen beansprucht sind, schließt ihre Kombination nicht aus. Bezugszeichen in den Ansprüchen sind nicht als Beschränkung des Schutzbereichs gedacht.

### Bezugszeichenliste

- 1: Vorrichtung
- 2: Leiterplatte
- 3: Kurzpulslaser
- 4: Ablationsstrahlung
- 5: Ablenkeinheit
- 6: Spiegel
- 7: Spiegel
- 8: Oberfläche
- 9: Scanobjektiv
- 10: Fokus
- 11: Plasma
- 12: Plasmastrahlung
- 13: Detektionsoptik
- 14: Einkoppeloptik
- 15: Faser
- 16: Multipliereinheit
- 17: Kollimieroptik
- 18: Bandpassfilter
- 19: Fokussieroptik
- 20: Messsignal
- 21: Analogelektronik
- 22: Messsignal
- 23: Triggersignal
- 24: schneller Schalter
- 25: invertierender Verstärker
- 26: verstärktes Messsignal
- 27: Integrator
- 28: Intensitätsmaß
- 29: Track-and-Hold Glied
- 30: Komparator
- 31: Referenzsignal
- 32a: analoger Ausgang
- 32b: digitaler Ausgang
- 33: Silizium Photomultiplier
- 34: Triggereinrichtung

## Patentansprüche

1. Vorrichtung (1) zur Laserablation eines Materials von einer Oberfläche (8) eines Werkstücks (2) mit
einem Pulslaser (3),
wobei der Pulslaser (3) derart ausgestaltet ist, dass der Pulslaser (3) in einem Betrieb der Vorrichtung (1) gepulste elektromagnetische Ablationsstrahlung (4) mit einer Pulsdauer von 100 Pikosekunden oder weniger, einer Schwerpunktwellenlänge und einer die Schwerpunktwellenlänge enthaltenden Bandbreite erzeugt und abstrahlt, und
einer Fokussieroptik (9),
wobei die Fokussieroptik (9) derart ausgestaltet und angeordnet ist, dass sie in dem Betrieb der Vorrichtung (1) die Ablationsstrahlung (4) auf die Oberfläche (8) des Werkstücks (2) fokussiert,
**dadurch gekennzeichnet, dass**
die Vorrichtung (1) weiterhin
eine Detektionsoptik (13),
ein dielektrisches Bandpassfilter (18) mit einer FWHM-Bandbreite von 1 Nanometer oder weniger,
einen Photomultiplier (33),
eine Triggereinrichtung (34) und
eine Auswerteeinrichtung (21) aufweist,
wobei die Detektionsoptik (13) derart ausgestaltet und angeordnet ist, dass sie in dem Betrieb der Vorrichtung (1) eine von einem Plasma an der Oberfläche (8) des Werkstücks (2) emittierte Plasmastrahlung (12) sammelt und auf den Photomultiplier (33) abbildet,
wobei das Bandpassfilter (18) in einem Strahlengang der Plasmastrahlung (12) zwischen der Oberfläche (8) und dem Photomultiplier (33) angeordnet ist,
wobei das Bandpassfilter (18) eine Durchlasswellenlänge für die Plasmastrahlung (12) aufweist, wobei die Durchlasswellenlänge außerhalb der Bandbreite des Pulslasers (3) liegt,
wobei die Auswerteeinrichtung (21) derart wirksam mit dem Photomultiplier (33) verbunden ist, dass die Auswerteeinrichtung (21) in dem Betrieb der Vorrichtung (1) ein eine Intensität der Plasmastrahlung (12) repräsentierendes Messignal von dem Photomultiplier (33) erhält,
wobei die Triggereinrichtung (34) für jeden Puls der Ablationsstrahlung (4) ein den Beginn des Pulses kennzeichnendes Triggersignal (23) erzeugt und ausgibt,
wobei die Auswerteeinrichtung (21) derart wirksam mit der Triggereinrichtung (34) verbunden ist, dass die Auswerteeinrichtung (21) in dem Betrieb der Vorrichtung (1) das Triggersignal (23) erhält, und
wobei die Auswerteeinrichtung (21) derart eingerichtet ist, dass sie in dem Betrieb der Vorrichtung (1)
für jeden Puls nach einer mit dem Triggersignal (23) startenden, vorgegebenen Verzögerung das Messsignal (22) über eine vorgegebene Integrationszeit integriert, so dass ein Intensitätsmaß (28) erhalten wird, und
ein Steuersignal (32a, 32b) aus dem Intensitätsmaß (28) erzeugt und ausgibt.

2. Vorrichtung (1) nach dem vorhergehenden Anspruch, wobei die Auswerteeinrichtung (21) derart wirksam mit zumindest dem Pulslaser (3) oder der Fokussieroptik oder einer Ablenkeinheit (5) verbunden ist, dass der Pulslaser (3) in dem Betrieb der Vorrichtung (1) das Steuersignal (32a, 32b) von der Auswerteeinrichtung (21) erhält, und wobei der Pulslaser (3) derart ausgestaltet ist, dass er in dem Betrieb der Vorrichtung (1) die Ablationsstrahlung (4) in Abhängigkeit von dem Steuersignal (32a, 32b) erzeugt.

3. Vorrichtung (1) nach einem der vorhergehenden Ansprüche, wobei die Auswerteeinrichtung (21) derart ausgestaltet ist, dass sie in dem Betrieb der Vorrichtung (1) eine Abtragskarte für eine folgende Ebene der Ablation in Abhängigkeit von den Steuersignal generiert.

4. Vorrichtung (1) einem der vorhergehenden Ansprüche, wobei die Auswerteeinrichtung (21) als analogelektronische Schaltung implementiert ist.

5. Vorrichtung (1) nach dem vorhergehenden Anspruch, wobei die analogelektronische Schaltung einen Schalter (24), und einen Integrator (27) umfasst,
wobei der Schalter (24) derart wirksam mit dem Photomultiplier (33) verbunden ist, dass der Schalter (24) in dem Betrieb der Vorrichtung (1) das Messsignal (22) von dem Photomultiplier (33) erhält,
wobei der Schalter (24) derart wirksam mit der Triggereinrichtung (34) verbunden ist, dass der Schalter (24) in dem Betrieb der Vorrichtung (1) das Triggersignal (23) von der Triggereinrichtung (34) erhält,
wobei der Schalter (24) derart ausgestaltet ist, dass der Schalter (24) in dem Betrieb der Vorrichtung (1) das Messsignal (22) nur nach dem Erhalt des Triggersignals (23) an den Verstärker (25) durchlässt,
wobei der Integrator (27) derart wirksam mit dem Schalter (24) verbunden ist, dass der Integrator (27) in dem Betrieb der Vorrichtung (1) das Messsignal (26) von dem Schalter (24) erhält, und
wobei der Integrator (27) derart ausgestaltet ist, dass er in dem Betrieb der Vorrichtung (1) das Messsignal (26) über die Integrationszeit integriert, so dass das Intensitätsmaß (28) erhalten wird.

6. Vorrichtung (1) nach einem der vorhergehenden Ansprüche, wobei die Auswerteeinrichtung (21) derart eingerichtet ist, dass die Integrationszeit in einem Bereich von 5 Nanosekunden bis 300 Nanosekunden liegt.

7. Vorrichtung (1) nach einem der vorhergehenden Ansprüche, wobei das Bandpassfilter (18) Bestandteil einer Einrichtung mit einer Mehrzahl von Bandpassfiltern ist, wobei die Einrichtung derart ausgestaltet ist, dass die Mehrzahl von Bandpassfiltern automatisiert gegeneinander austauschbar sind.

8. Vorrichtung (1) nach einem der vorhergehenden Ansprüche, wobei der Photomultiplier (33) eine Bandbreite von 100 Megahertz oder mehr aufweist.

9. Vorrichtung (1) nach einem der vorhergehenden Ansprüche, wobei die Detektionsoptik (13) eine optische Faser (15) mit einem Kerndurchmesser von mehr als 750 Mikrometern umfasst, wobei die Faser derart angeordnet ist, dass sie in dem Betrieb der Vorrichtung (1) die Plasmastrahlung (12) von der Oberfläche (8) zu dem Photomultiplier (33) leitet, und wobei eine Ablenkoptik (5) derart angeordnet und ausgestaltet ist, dass in dem Betrieb der Vorrichtung (1) ein Fokus der Ablationsstrahlung (4) gegenüber einer Endfläche der Faser (15) bewegbar ist.

10. Vorrichtung (1) nach einem der vorhergehenden Ansprüche, wobei die Vorrichtung (1) mindestens ein erstes und ein zweites dielektrisches Bandpassfilter (18) mit einer ersten und einer von der ersten verschiedenen zweiten Durchlasswellenlänge aufweist, wobei die Vorrichtung (1) mindestens einen ersten und einen zweiten Photomultiplier (33) aufweist, wobei das erste und das zweite Bandpassfilter (18) sowie der erste und der zweite Photomultiplier (33) derart angeordnet sind, dass mit dem ersten Photomultiplier (33) Plasmastrahlung (12) mit einer ersten Wellenlänge und mit dem zweiten Photomultiplier (33) Plasmastrahlung (12) mit einer zweiten Wellenlänge erfassbar ist.

11. Vorrichtung (1) nach einem der vorhergehenden Ansprüche, wobei der Pulslaser (3) derart ausgestaltet ist, dass er in dem Betrieb der Vorrichtung (1) die Pulse mit einer Repetitionsrate aus einem Bereich von 50 Kilohertz bis 1 Megahertz erzeugt.

12. Vorrichtung (1) nach einem der vorhergehenden Ansprüche, wobei die Triggereinrichtung einen Triggerdetektor und ein Auskoppelement umfasst, wobei das Auskoppelement derart in einem Strahlengang zumindest der Plasmastrahlung oder der Ablationsstrahlung in einer Strahlrichtung nach der Oberfläche des Werkstücks angeordnet ist, dass das Auskoppelement einen Teil der Plasmastrahlung oder der Ablationsstrahlung auf den Triggerdetektor lenkt, wobei der Triggerdetektor das Triggersignal erzeugt.

13. Verfahren zur Laserablation eines Materials von einer Oberfläche (8) eines Werkstücks (2) mit den Schritten
Erzeugen und Abstrahlen gepulster elektromagnetischer Ablationsstrahlung (4) mit einer Pulsdauer von 100 Pikosekunden oder weniger, einer Schwerpunktwellenlänge und einer die Schwerpunktwellenlänge enthaltenden Bandbreite, und
Fokussieren der Ablationsstrahlung (4) auf die Oberfläche (8) des Werkstücks (2), so dass von der Oberfläche (8) des Werkstücks (2) Material ablatiert wird,
**dadurch gekennzeichnet, dass** das Verfahren weiterhin die Schritte aufweist
Erzeugen eines den Beginn des Pulses kennzeichnenden Triggersignals für jeden Puls der Ablationsstrahlung (4),
Abbilden einer von einem durch die Ablationsstrahlung (4) an der Oberfläche (8) des Werkstücks (2) generiertem Plasma emittierten Plasmastrahlung (12) auf einen Photomultiplier (33),
Filtern der Plasmastrahlung (12) zwischen der Oberfläche (8) und dem Photomultiplier (33) mit einem dielektrischen Bandpassfilter mit einer FWHM Bandbreite von 1 Nanometer oder weniger, wobei das Bandpassfilter eine Durchlasswellenlänge aufweist, wobei die Durchlasswellenlänge außerhalb der Bandbreite des Pulslasers (3) liegt,
Erfassen einer Intensität der Plasmastrahlung (12) mit dem Photomultiplier (33), wobei der Photomultiplier (33) ein die Intensität repräsentierendes Messsignal (22) ausgibt,
Integrieren des Messsignals (22) für jeden Puls nach einer mit dem Triggersignal startenden, vorgegebenen Verzögerung über eine vorgegebene Integrationszeit, so dass ein Intensitätsmaß (28) erhalten wird,
Erzeugen eines Steuersignals (32a, 32b) aus dem Intensitätsmaß (28) und Ausgeben des Steuersignals (32a, 32b).

14. Verfahren nach dem vorhergehenden Anspruch, wobei das Werkstück (2) eine Leiterplatte mit einer elektrisch isolierenden Trägerschicht, einer ersten elektrisch leitenden Schicht und einer zweiten durch die Trägerschicht von der ersten isolierten elektrisch leitenden Schicht ist, wobei durch das Ablatieren ein Durchgang von der ersten Schicht zu der zweiten Schicht bereitgestellt wird.

15. Verfahren nach Anspruch 11 oder 12, wobei die Ablationsstrahlung (4) über die Oberfläche (8) des Werkstücks (2) geführt wird.
